# FASCICULE DE BREVET EUROPEEN

(11) **EP 3 324 431 B1**
(45) Date de publication et mention de la délivrance du brevet: **07.08.2019**
(21) Numéro de dépôt: 17202280.8
(22) Date de dépôt: 17.11.2017
(51) Int. Cl.: H01L 23/14, H01L 21/48, H05K 1/09, H05K 3/12, H01L 23/498, H05K 1/03

(54) **CIRCUIT ÉLECTRONIQUE ET SON PROCÉDÉ DE FABRICATION**
ELEKTRONISCHER SCHALTKREIS UND SEIN HERSTELLUNGSVERFAHREN
ELECTRONIC CIRCUIT AND METHOD FOR MANUFACTURING SAME

(30) Priorité: 21.11.2016 FR 1661302
(43) Date de publication de la demande: 23.05.2018
(73) Titulaire: Commissariat à l'Energie Atomique et aux Energies Alternatives, 75015 Paris (FR)
(72) Inventeur: HAON, Olivier, 38960 SAINT-ETIENNE-DE-CROSSEY (FR); ALIANE, Abdelkader, 38100 GRENOBLE (FR); BENWADIH, Mohammed, 94500 CHAMPIGNY-SUR-MARNE (FR)
(74) Mandataire: Cabinet Beaumont

(56) Documents cités:
- EP-A2- 0 678 918
- WO-A1-2014/087882
- US-A1- 2010 196 703

## Description

### Domaine

La présente demande concerne les circuits électroniques et leurs procédés de fabrication.

### Exposé de l'art antérieur

WO2014/087882 divulgue une une couche métallique dotée sur un substrat ayant une température de transition vitreuse égale ou supérieure à 200 °C. Pour certaines applications, il est souhaitable de pouvoir former des pistes conductrices électriquement à partir du dépôt d'une encre conductrice électriquement, notamment une encre contenant de l'argent, sur un substrat en polymère. Un exemple d'application concerne les circuits électroniques comprenant des antennes comportant une piste conductrice formée sur un substrat en polymère.

La formation des pistes conductrices comprend généralement le dépôt de motifs de l'encre conductrice sous forme liquide ou visqueuse sur le substrat et le chauffage de l'encre conductrice pour obtenir les pistes conductrices. La conductivité électrique des pistes conductrices obtenues par ce procédé est généralement d'autant plus élevée que l'étape de chauffage, également appelée recuit thermique, a été réalisée à une température élevée. Toutefois, lorsque l'étape de chauffage est réalisée à une température supérieure à la température de transition vitreuse du polymère composant le substrat, on peut observer la pénétration partielle de l'encre dans le substrat et la pénétration partielle du polymère composant le substrat dans l'encre conductrice. On peut en outre observer une déformation des motifs d'encre déposés sur le substrat et la déformation du substrat. Les performances des pistes conductrices sont alors généralement fortement dégradées.

Il existe des polymères dont la température de transition vitreuse est élevée comme par exemple le poly(4,4'-oxydiphénylène-pyromellitimide), plus connu sous l'appellation Kapton, et dont la température de transition vitreuse est de l'ordre de 400 °C. Toutefois, l'utilisation de tels matériaux n'est pas envisageable pour de nombreuses applications notamment pour des raisons de coût.

Certains polymères, tels que le polycarbonate (PC), présentent des propriétés thermiques, mécaniques et optiques qui les rendent intéressants pour une utilisation comme substrats de circuits électroniques. Toutefois, ces matériaux peuvent avoir une température de transition vitreuse inférieure à 200 °C, notamment inférieure à 150 °C. Il n'est alors pas possible de réaliser une étape de chauffage suite au dépôt d'une encre conductrice sur un tel substrat à une température suffisamment élevée pour obtenir des pistes conductrices ayant une conductivité électrique élevée.

Il serait donc souhaitable de pouvoir utiliser un substrat en polymère dont la température de transition vitreuse est inférieure à 200 °C et sur lequel sont formées des pistes conductrices par dépôt d'une encre conductrice et chauffage de l'encre conductrice à une température supérieure ou égale à la température de transition vitreuse du polymère.

### Résumé

Un objet d'un mode de réalisation est de pallier tout ou partie des inconvénients des circuits électroniques comprenant un substrat en un polymère et des pistes conductrices électriquement sur le substrat et de leurs procédés de fabrication décrits précédemment.

Un autre objet d'un mode de réalisation est que la température de transition vitreuse du polymère est inférieure à 200 °C.

Un autre objet d'un mode de réalisation est que les pistes conductrices sont formées par dépôt d'une encre conductrice et chauffage de l'encre conductrice à une température supérieure ou égale à 200 °C.

Un autre objet d'un mode de réalisation est que les pistes conductrices sont formées par des techniques d'impression.

Un autre objet d'un mode de réalisation est que le circuit électronique peut être fabriqué à coût réduit.

Ainsi, un mode de réalisation prévoit un circuit électronique comprenant :
un substrat en un premier polymère ayant une première température de transition vitreuse inférieure à 200 °C, le substrat ayant des première et deuxième faces opposées ;
une première couche ou des premières pistes d'un deuxième polymère sur la première face ;
une deuxième couche ou des deuxièmes pistes du deuxième polymère ou d'un troisième polymère sur la deuxième face, les deuxième et troisième polymères étant différents du premier polymère et ayant une deuxième température de transition vitreuse supérieure à 200 °C ; et
des troisièmes pistes conductrices électriquement sur la première couche ou les premières pistes.

Selon un mode de réalisation, le premier polymère est choisi parmi le groupe comprenant le polycarbonate (PC), le poly(téréphtalate d'éthylène) (PET), le poly(naphtalate d'éthylène) (PEN), les polymères styréniques (notamment le copolymère styrène-acrylonitrile (SAN), l'acrylonitrile styrène acrylate (ASA) et l'acrylonitrile butadiène styrène (ABS)), le polyméthacrylate de méthyle (PMMA), les polyuréthanes thermoplastiques (TPU, notamment les TPU polyester, TPU polyéther), le polyfluorure de vinylidène (PVDF), les résines polyvinyliques (notamment l'acétate de polyvinyle (PVAC), l'alcool polyvinylique (PVAL), le polyvinyl formal (PVFM) et le poly(butyral vinylique) (PVB)), le copolymère d'éthylène et de chlorotrifluoroéthylène (ECTFE), les polypropylènes (PP), et un mélange d'au moins deux de ces composés.

Selon un mode de réalisation, l'épaisseur du substrat est comprise entre 30 µm et 300 µm.

Selon un mode de réalisation, les deuxième et troisième polymères sont choisis parmi le groupe comprenant les polyimides, le polybenzimidazole (PBI), le polyétherimide (PEI), le polyamide-imide (PAI), le polyéthersulfone (PES) et un mélange d'au moins deux de ces composés.

Selon un mode de réalisation, le substrat, la première couche ou les premières pistes et/ou la deuxième couche ou les deuxièmes pistes comprennent, en outre, un pigment minéral, un pigment organique, ou un colorant.

Selon un mode de réalisation, l'épaisseur de la première couche, des premières pistes, de la deuxième couche et/ou des deuxièmes pistes est comprise entre 10 nm et 300 nm.

Selon un mode de réalisation, l'épaisseur de la première couche, des premières pistes, de la deuxième couche et/ou des deuxièmes pistes est comprise entre 10 µm et 25 µm.

Selon un mode de réalisation, l'épaisseur des troisièmes pistes est comprise entre 500 nm et 25 µm.

Selon un mode de réalisation, les premières pistes et/ou les deuxièmes pistes comprennent des bandes parallèles disposées avec un pas qui n'est pas constant.

Un mode de réalisation prévoit également un procédé de fabrication d'un circuit électronique comprenant les étapes suivantes :
a) prévoir un substrat en un premier polymère ayant une première température de transition vitreuse inférieure à 200 °C, le substrat ayant des première et deuxième faces opposées ;
b) former une première couche ou des premières pistes d'un deuxième polymère sur la première face et une deuxième couche ou des deuxièmes pistes du deuxième polymère ou d'un troisième polymère sur la deuxième face, les deuxième et troisième polymères étant différents du premier polymère et ayant une deuxième température de transition vitreuse supérieure à 200 °C ; et
c) former des troisièmes pistes conductrices électriquement sur la première couche ou les premières pistes.

Selon un mode de réalisation, l'étape c) comprend successivement le dépôt d'une encre conductrice sur la première couche ou les premières pistes et le séchage de l'encre à une température supérieure à la première température de transition vitreuse.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 à 4 sont des vues en coupe, partielles et schématiques, de modes de réalisation d'un circuit électronique ;
les figures 5A à 5D sont des vues en coupe, partielles et schématiques, de structures obtenues à des étapes successives d'un mode de réalisation d'un procédé de fabrication du circuit électronique de la figure 1 ; et
les figures 6A à 6D sont des vues en coupe, partielles et schématiques, de structures obtenues à des étapes successives d'un mode de réalisation d'un procédé de fabrication du circuit électronique de la figure 2.

### Description détaillée

De mêmes éléments ont été désignés par de mêmes références dans les différentes figures. Par souci de clarté, seuls les éléments utiles à la compréhension des modes de réalisation décrits ont été représentés et sont détaillés. Sauf précision contraire, les expressions "approximativement", "sensiblement", "environ" et "de l'ordre de" signifient à 10 % près, de préférence à 5 % près.

Dans la suite de la description, on appelle "matériau isolant électriquement" ou "matériau diélectrique" un matériau dont la résistivité électrique est supérieure à 10⁵ Ω.m et on appelle "matériau conducteur électriquement" un matériau dont la résistivité électrique est inférieure à 0,1 Ω.m.

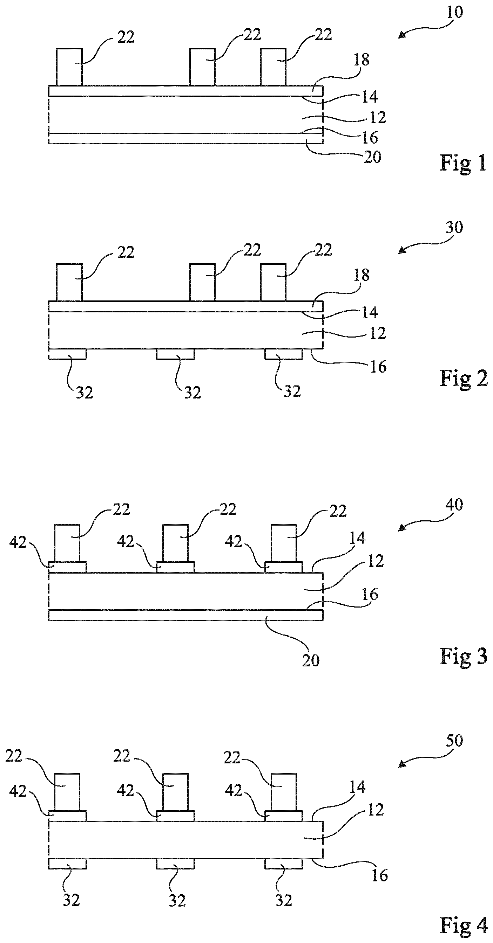

La figure 1 est une vue en coupe, partielle et schématique, d'un mode de réalisation d'un circuit électronique 10. Le circuit 10 comprend un substrat 12 en un premier polymère comprenant deux faces 14, 16 opposées, par exemple sensiblement planes. Le circuit 10 comprend, en outre, une couche ou film 18 en un deuxième polymère, différent du premier polymère, sur la face 14, de préférence au contact de la face 14, et une couche ou film 20 du deuxième polymère ou d'un troisième polymère, différent du premier polymère et du deuxième polymère, sur la face 16, de préférence au contact de la face 16. Le circuit 10 comprend, en outre, des pistes conductrices électriquement 22 sur la couche 18, de préférence au contact de la couche 18.

Le premier polymère a une température de transition vitreuse inférieure à 200 °C, de préférence inférieure à 150 °C. Selon un mode de réalisation, le premier polymère est choisi parmi le groupe comprenant le polycarbonate (PC), le poly(téréphtalate d'éthylène) (PET), le poly(naphtalate d'éthylène) (PEN), les polymères styréniques (notamment le copolymère styrène-acrylonitrile (SAN), l'acrylonitrile styrène acrylate (ASA) et l'acrylonitrile butadiène styrène (ABS)), le polyméthacrylate de méthyle (PMMA), les polyuréthanes thermoplastiques (TPU, notamment les TPU polyester, TPU polyéther), le polyfluorure de vinylidène (PVDF), les résines polyvinyliques (notamment l'acétate de polyvinyle (PVAC), l'alcool polyvinylique (PVAL), le polyvinyl formal (PVFM) et le poly(butyral vinylique) (PVB)), le copolymère d'éthylène et de chlorotrifluoroéthylène (ECTFE) les polypropylènes (PP) et un mélange d'au moins deux de ces composés.

L'épaisseur du substrat 12 est comprise entre 30 µm et 300 µm.

Les deuxième et troisième polymères ont une température de transition vitreuse supérieure à 200 °C. Selon un mode de réalisation, les deuxième et troisième polymères sont choisis parmi le groupe comprenant le polyimide (PI), le polybenzimidazole (PBI), le polyétherimide (PEI), le polyamide-imide (PAI), le polyéthersulfone (PES) et un mélange d'au moins deux de ces composés. L'épaisseur de la couche 18 et/ou l'épaisseur de la couche 20 dépendent de l'application souhaitée. S'il est principalement recherché la protection du substrat 12 contre la pénétration de l'encre utilisée pour la réalisation des pistes conductrices 22, l'épaisseur de la couche 18 et/ou l'épaisseur de la couche 20 peuvent être inférieures à 1 µm, par exemple comprises entre 10 nm et 300 nm. S'il est recherché une réduction des déformations du substrat 12 lors de la fabrication du circuit électronique 10, l'épaisseur de la couche 18 et/ou l'épaisseur de la couche 20 peuvent être supérieures à 10 µm, par exemple comprises entre 10 µm et 25 µm.

On peut combiner à ces polymères un pigment minéral (par exemple le dioxyde de titane, le titanate de nickel, le titanate de chrome, l'oxyde de fer, l'oxyde de chrome, l'aluminate de cobalt, le noir de carbone), un pigment organique (notamment les composés azoïques, phtalocyanines, thio-indigoïdes, quinacridones, dioxazine, pérylène, anthraquinones), ou un colorant (notamment un dérivé anthraquinonique, à complexe métallifère), en fonction du polymère de base, afin d'obtenir en plus un aspect décoratif et/ou de masquage.

Les pistes conductrices 22 sont formées par dépôt puis chauffage d'une encre conductrice électriquement. L'encre conductrice électriquement contient notamment un solvant dans lequel sont dispersées des particules conductrices électriquement. Les particules conductrices électriquement sont de préférence des particules ou des nanofils métalliques en un matériau choisi parmi le groupe comprenant l'argent, le cuivre, l'or, le nickel, l'aluminium, le carbone, ou des particules en un polymère conducteur (par exemple le PEDOT:PSS ou la polyaniline). L'épaisseur des pistes conductrices 22 après l'opération de chauffage est, par exemple, comprise entre 500 nm et 25 µm.

La figure 2 est une vue en coupe, partielle et schématique, d'un autre mode de réalisation d'un circuit électronique 30. Le circuit électronique 30 comprend l'ensemble des éléments du circuit électronique 10 représenté en figure 1 à la différence que la couche 20 est remplacée par des pistes 32 du deuxième polymère ou du troisième polymère sur la face 16 du substrat 12, de préférence au contact de la face 16 du substrat 12. Les pistes 32 peuvent être disjointes ou jointives.

L'épaisseur des pistes 32 est comprise entre 10 nm et 300 nm. Les pistes 32 peuvent correspondre à des bandes, notamment disposées de façon parallèle ou selon une grille. Les pistes 32 peuvent correspondre à une piste unique s'étendant par exemple en spirale sur la face 16. L'écartement maximal entre deux pistes 32 adjacentes est compris entre 150 µm et 200 µm.

Selon un mode de réalisation, les pistes 32 peuvent être disposées sur la face 16 de façon sensiblement périodique. Selon un autre mode de réalisation, les pistes 32 peuvent être disposées sur la face 16 avec un pas variable, par exemple sous la forme de bandes parallèles dont le pas est plus petit au centre de la face 16 et augmente au fur et à mesure que l'on s'éloigne du centre de la face 16 pour atteindre un pas maximal au niveau des bords de la face 16 parallèles aux pistes 32. Selon un autre mode de réalisation, la largeur des pistes 32 peut être variable, les pistes 32 étant par exemple disposées sous la forme de bandes parallèles dont la largeur est plus petite au centre de la face 16 et augmente au fur et à mesure que l'on s'éloigne du centre de la face 16 pour atteindre une largeur maximale au niveau des bords de la face 16 parallèles aux pistes 32. Selon un autre mode de réalisation, à la fois le pas et la largeur des pistes 52 peuvent être variables. A titre d'exemple, au centre de la face 16, le pas des pistes 32 peut être d'environ 50 µm, ce qui correspond par exemple à un écartement entre pistes adjacentes de 30 µm pour une largeur de pistes 32 de 20 µm, et au niveau des bords de la face 16 parallèles aux pistes 32, le pas peut être de 300 µm à 400 µm, ce qui correspond par exemple à un écartement de 100 µm à 200 µm pour une largeur de pistes 32 de 200 µm. Un tel agencement permet d'améliorer la répartition des contraintes mécaniques dans tout le substrat 10, notamment lorsque des défauts sont présents dans le substrat 10.

La figure 3 est une vue en coupe, partielle et schématique, d'un autre mode de réalisation d'un circuit électronique 40. Le circuit électronique 40 comprend l'ensemble des éléments du circuit électronique 10 représenté en figure 1 à la différence que la couche 18 est remplacée par des pistes 42 du deuxième polymère sur la face 14 du substrat 12, de préférence au contact de la face 14 du substrat 12. Les pistes 42 peuvent être disjointes ou jointives. Les pistes conductrices 22 reposent sur les pistes 42. De préférence, la forme des pistes 42 peut suivre celle des pistes conductrices 22. L'épaisseur des pistes 42 peut être la même que la couche 18.

La figure 4 est une vue en coupe, partielle et schématique, d'un autre mode de réalisation d'un circuit électronique 50. Le circuit électronique 50 comprend l'ensemble des éléments du circuit électronique 10 représenté en figure 1, à la différence que la couche 18 est remplacée par les pistes 42 du deuxième polymère sur la face 14 du substrat 12, de préférence au contact de la face 14 du substrat 12, comme pour le circuit électronique 40 représenté en figure 3. En outre, la couche 20 est remplacée par les pistes 32 du deuxième polymère ou du troisième polymère sur la face 16 du substrat 12, de préférence au contact de la face 16 du substrat 12, comme pour le circuit électronique 30 représenté en figure 3.

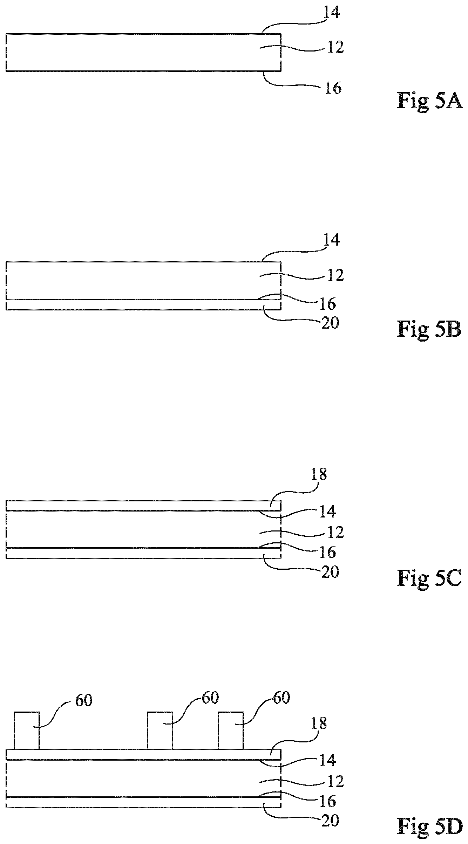

Les figures 5A à 5D sont des vues en coupe, partielles et schématiques, de structures obtenues à des étapes successives d'un mode de réalisation d'un procédé de fabrication du circuit électronique 10 de la figure 1.

La figure 5A représente la structure obtenue après la formation du substrat 12 du premier polymère, par exemple du polycarbonate. Une étape de chauffage du substrat 12, par exemple à 80 °C pendant 12 heures peut être prévue.

La figure 5B représente la structure obtenue après la formation de la couche 20 sur la face 16 du substrat 12. La couche 20 peut être formée par dépôt du deuxième polymère ou du troisième polymère sur la face 16 et le chauffage de la structure obtenue à une température inférieure à la température de transition vitreuse du premier polymère, par exemple à 100 °C pendant 15 minutes lorsque le premier polymère est le polyacrylate. Le dépôt peut correspondre à un dépôt par impression par jet d'encre, héliographie, sérigraphie, flexographie, revêtement par pulvérisation (en anglais spray coating) ou dépôt de gouttes (en anglais drop-casting) ou un dépôt par voie liquide, par pulvérisation cathodique ou par évaporation. Il peut s'agir notamment de procédés du type dépôt à la tournette, revêtement par pulvérisation, revêtement par filière (en anglais slot-die coating) ou revêtement à la lame (en anglais blade-coating).

La figure 5C représente la structure obtenue après la formation de la couche 18 sur la face 14 du substrat 12. La couche 18 peut être formée par dépôt du deuxième polymère sur la face 14 et le chauffage de la structure obtenue à une température inférieure à la température de transition vitreuse du premier polymère, par exemple à 100 °C pendant 15 minutes lorsque le premier polymère est le polyacrylate. Les procédés décrits précédemment pour le dépôt de la couche 20 peuvent également être mis en oeuvre pour le dépôt de la couche 18.

La figure 5D représente la structure obtenue après la formation de motifs 60 en une encre conductrice aux emplacements souhaités des pistes conductrices 22. Le procédé de formation des motifs 60 de l'encre conductrice peut correspondre à un procédé dit additif, par exemple par impression directe de l'encre conductrice aux emplacements souhaités, par exemple par impression par jet d'encre, héliographie, sérigraphie, flexographie, revêtement par pulvérisation (en anglais spray coating) ou dépôt de gouttes (en anglais drop-casting). Le procédé de formation des motifs 60 de l'encre conductrice peut correspondre à un procédé dit soustractif, dans lequel l'encre conductrice est déposée sur la totalité de la structure et dans lequel les portions non utilisées sont ensuite retirées, par exemple par photolithographie ou ablation laser. Selon le matériau considéré, le dépôt sur la totalité de la structure peut être réalisé par exemple par voie liquide, par pulvérisation cathodique ou par évaporation. Il peut s'agir notamment de procédés du type dépôt à la tournette, revêtement par pulvérisation, héliographie, revêtement par filière (en anglais slot-die coating), revêtement à la lame (en anglais blade-coating), flexographie ou sérigraphie.

L'encre conductrice comprend des particules métalliques dispersées dans un solvant. De façon avantageuse, la présence de la couche 18 permet d'utiliser des encres dont le solvant peut ne pas être compatible avec le premier polymère. Dans le cas où le premier polymère est le polycarbonate, des exemples de solvants qui sont compatibles avec le polycarbonate sont l'eau, l'éthanol et l'isopropanol. Dans le cas où le premier polymère est le polycarbonate, des exemples de solvants qui ne sont pas compatibles avec le polycarbonate sont le cyclopentanone, le toluène, l'éthylène glycol et le butylacétate.

Le procédé comprend, en outre, une étape de chauffage de la structure obtenue à une température supérieure à la température de transition vitreuse du premier polymère, par exemple 150 °C pendant 30 minutes lorsque le premier polymère est le polyacrylate. La structure représentée en figure 1 est alors obtenue.

Les inventeurs ont mis en évidence que la présence de la couche 18 permet d'empêcher, lors de l'étape de chauffage à une température supérieure à la température de transition vitreuse du premier polymère, le mélange de l'encre conductrice et du premier polymère. En outre, la présence des couches 18 et 20 permet d'empêcher que le substrat 12 se déforme lors de l'étape de chauffage à une température supérieure à la température de transition vitreuse du premier polymère.

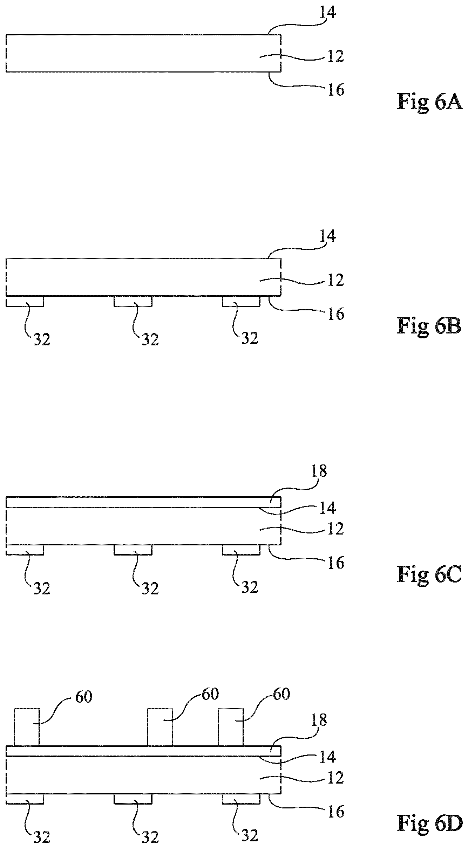

Les figures 6A à 6D sont des vues en coupe, partielles et schématiques, de structures obtenues à des étapes successives d'un mode de réalisation d'un procédé de fabrication du circuit électronique 30 de la figure 2.

La figure 6A représente la structure obtenue après la formation du substrat 12 du premier polymère, par exemple du polycarbonate.

La figure 6B représente la structure obtenue après la formation des pistes 32 sur la face 16 du substrat 12. Les pistes 32 peuvent être formées par dépôt du deuxième polymère ou du troisième polymère sur la face 16 et le chauffage de la structure obtenue à une température inférieure à la température de transition vitreuse du premier polymère. Les procédés de dépôt du deuxième polymère ou du troisième polymère sur la face 16 sont les procédés décrits précédemment en relation avec la figure 5D pour le dépôt des motifs 60.

La figure 6C représente la structure obtenue après la formation de la couche 18 sur la face 14 du substrat 12. La couche 18 peut être formée comme cela a été décrit précédemment en relation avec la figure 5C.

La figure 6D représente la structure obtenue après la formation des motifs 60 en une encre conductrice aux emplacements souhaités des pistes conductrices 22 comme cela a été décrit précédemment en relation avec la figure 5D.

Le procédé comprend, en outre, une étape de chauffage de la structure obtenue à l'étape 6D à une température supérieure à la température de transition vitreuse du premier polymère. La structure représentée en figure 2 est alors obtenue.

Des essais ont été réalisés. Des premiers circuits électroniques ont été fabriqués ayant la structure représentée en figure 1 à la différence que les couches 18 et 20 n'étaient pas présentes. Le substrat 12 était du polycarbonate et avait une épaisseur de 175 µm. Les pistes conductrices 22 étaient formées à partir de l'encre argent commercialisée par la société Novacentrix sous l'appellation Metalon HPS-021LV. Un recuit thermique a été réalisé dans un four infrarouge pendant 30 minutes à 150 °C. Des deuxièmes circuits électroniques ont été fabriqués. Les deuxièmes circuits électroniques avaient la même structure que les premiers circuits électroniques et comprenaient en outre les couches 18 et 20 en polyimide ayant une épaisseur comprise entre 10 nm et 400 nm.

Les résistances exprimées en ohm par carré des pistes conductrices 22 des premiers et deuxièmes circuits ont été mesurées. Les résultats sont regroupés dans le tableau I suivant :

**Tableau I**

| Température recuit (°C) | Résistance (ohm par carré) Seconds circuits | Résistance (ohm par carré) Premiers circuits |
|---|---|---|
| 100 | 40 | 40 |
| 125 | 23 | 23 |
| 145 | 19 | 2000 |
| 175 | 15 | >2000 |
| 200 | 13 | >2000 |

Lorsque les couches 18 et 20 sont présentes, une diminution de la résistance des pistes conductrices 22 est observée lorsque la température de recuit augmente, tandis que, lorsque les couches 18 et 20 ne sont pas présentes, une augmentation de la résistance des pistes conductrices 22 est observée lorsque la température de recuit augmente.

En outre, les inventeurs ont mis en évidence que lorsque les couches 18 et 20 du circuit électronique 10 représenté en figure 1, la couche 18 et les pistes 32 du circuit électronique 30 représenté en figure 2, les pistes 42 et la couche 20 du circuit électronique 40 représenté en figure 3 ou les pistes 42 et les pistes 32 du circuit électronique 50 représenté en figure 4 sont présentes, une réduction des déformations du substrat 12 est observée.

Des simulations ont été réalisées. Chaque simulation a été réalisée avec un substrat correspondant à une feuille en polycarbonate rectangulaire de 320 mm par 380 mm ayant une épaisseur de 175 µm dont une face est recouverte d'une couche du polyimide commercialisé par la société Nissan Chemical Industries sous l'appellation Sunever series 2 SE 7492 et ayant une épaisseur de 20 µm. Un recuit thermique de 150 °C de 30 minutes à 60 minutes a été réalisé. Le substrat était encastré sur un bord, le bord opposé étant laissé libre.

Dans une première simulation, la face du substrat opposée à la face recouverte de la couche de polyimide était laissée libre. Une flèche maximale de 17 µm par rapport à un plan horizontal vers la face sur laquelle repose la couche de polyimide est obtenue.

Dans une deuxième simulation, la face du substrat opposée à la face recouverte de la couche de polyimide était recouverte de bandes parallèles du polyimide PI-7492 avec une épaisseur variant de 5 µm à 10 µm et un pas de 150 µm à 200 µm et une largeur de 100 µm. Une flèche maximale de 13 µm par rapport à un plan horizontal vers la face sur laquelle repose la couche de polyimide est obtenue. Une réduction de la flèche maximale a donc été obtenue.

## Revendications

1. Circuit électronique (10 ; 20 ; 30 ; 40) comprenant :
un substrat (12) en un premier polymère ayant une première température de transition vitreuse inférieure à 200 °C, le substrat ayant des première et deuxième faces (14, 16) opposées ;
une première couche (18) ou des premières pistes (42) d'un deuxième polymère sur la première face ;
une deuxième couche (20) ou des deuxièmes pistes (32) du deuxième polymère ou d'un troisième polymère sur la deuxième face, les deuxième et troisième polymères étant différents du premier polymère et ayant une deuxième température de transition vitreuse supérieure à 200 °C ; et
des troisièmes pistes (22) conductrices électriquement sur la première couche ou les premières pistes.

2. Circuit électronique selon la revendication 1, dans lequel le premier polymère est choisi parmi le groupe comprenant le polycarbonate (PC), le poly(téréphtalate d'éthylène) (PET), le poly(naphtalate d'éthylène) (PEN), les polymères styréniques (notamment le copolymère styrène-acrylonitrile (SAN), l'acrylonitrile styrène acrylate (ASA) et l'acrylonitrile butadiène styrène (ABS)), le polyméthacrylate de méthyle (PMMA), les polyuréthanes thermoplastiques (TPU, notamment les TPU polyester, TPU polyéther), le polyfluorure de vinylidène (PVDF), les résines polyvinyliques (notamment l'acétate de polyvinyle (PVAC), l'alcool polyvinylique (PVAL), le polyvinyl formal (PVFM) et le poly(butyral vinylique) (PVB)), le copolymère d'éthylène et de chlorotrifluoroéthylène (ECTFE), les polypropylènes (PP), et un mélange d'au moins deux de ces composés.

3. Circuit électronique selon la revendication 1 ou 2, dans lequel l'épaisseur du substrat (12) est comprise entre 30 µm et 300 µm.

4. Circuit électronique selon l'une quelconque des revendications 1 à 3, dans lequel les deuxième et troisième polymères sont choisis parmi le groupe comprenant les polyimides, le polybenzimidazole (PBI), le polyétherimide (PEI), le polyamide-imide (PAI), le polyéthersulfone (PES) et un mélange d'au moins deux de ces composés.

5. Circuit électronique selon l'une quelconque des revendications 1 à 4, dans lequel le substrat (12), la première couche (18) ou les premières pistes (42) et/ou la deuxième couche (20) ou les deuxièmes pistes (32) comprennent, en outre, un pigment minéral, un pigment organique, ou un colorant.

6. Circuit électronique selon l'une quelconque des revendications 1 à 5, dans lequel l'épaisseur de la première couche (18), des premières pistes (42), de la deuxième couche (20) et/ou des deuxièmes pistes (32) est comprise entre 10 nm et 300 nm.

7. Circuit électronique selon l'une quelconque des revendications 1 à 5, dans lequel l'épaisseur de la première couche (18), des premières pistes (42), de la deuxième couche (20) et/ou des deuxièmes pistes (32) est comprise entre 10 µm et 25 µm.

8. Circuit électronique selon l'une quelconque des revendications 1 à 7, dans lequel l'épaisseur des troisièmes pistes (22) est comprise entre 500 nm et 25 µm.

9. Circuit électronique selon l'une quelconque des revendications 1 à 8, dans lequel les premières pistes (42) et/ou les deuxièmes pistes (32) comprennent des bandes parallèles disposées avec un pas qui n'est pas constant.

10. Procédé de fabrication d'un circuit électronique (10 ; 20 ; 30 ; 40) comprenant les étapes suivantes :
a) prévoir un substrat (12) en un premier polymère ayant une première température de transition vitreuse inférieure à 200 °C, le substrat ayant des première et deuxième faces (14, 16) opposées ;
b) former une première couche (18) ou des premières pistes (42) d'un deuxième polymère sur la première face et une deuxième couche (20) ou des deuxièmes pistes (32) du deuxième polymère ou d'un troisième polymère sur la deuxième face, les deuxième et troisième polymères étant différents du premier polymère et ayant une deuxième température de transition vitreuse supérieure à 200 °C ; et
c) former des troisièmes pistes (22) conductrices électriquement sur la première couche ou les premières pistes.

11. Procédé selon la revendication 10, dans lequel l'étape c) comprend successivement le dépôt d'une encre conductrice sur la première couche (18) ou les premières pistes (42) et le séchage de l'encre à une température supérieure à la première température de transition vitreuse.

## Patentansprüche

1. Elektronischer Schaltkreis (10; 20; 30; 40), der Folgendes aufweist:
ein Substrat (12) aus einem ersten Polymer mit einer ersten Glasübergangstemperatur von weniger als 200 °C, wobei das Substrat gegenüberliegende erste und zweite Oberflächen (14, 16) aufweist;
eine erste Schicht (18) oder erste Bahnen (42) eines zweiten Polymers auf der ersten Oberfläche;
eine zweite Schicht (20) oder zweite Bahnen (32) des zweiten Polymers oder eines dritten Polymers auf der zweiten Oberfläche, wobei sich das zweite und dritte Polymer vom ersten Polymer unterscheiden und eine zweite Glasübergangstemperatur von mehr als 200 °C aufweisen; und
dritte elektrisch leitende Bahnen (22) auf der ersten Schicht oder den ersten Bahnen.

2. Der elektronische Schaltkreis nach Anspruch 1, wobei das erste Polymer aus der Gruppe ausgewählt wird, die Folgendes aufweist:
Polycarbonat bzw. PC, Polyethylenterephthalat bzw. PET, Polyethylennaphthalat bzw. PEN, Styrol-Polymere, und zwar insbesondere das Styrol-Acrylnitril- bzw. SAN-Copolymer, Acrylnitril-Styrol-Acrylat bzw. ASA und Acrylnitril-Butadien-Styrol bzw. ABS, Polymethylmethacrylat bzw. PMMA, thermoplastische Polyurethane bzw. TPU, und zwar insbesondere Polyester-basierte TPU, Polyether-basierte TPU, Polyvinylidenfluorid bzw. PVDF, Polyvinylharze, und zwar insbesondere Polyvinylacetat bzw. PVAC, Polyvinylalkohol bzw. PVAL, Polyvinylformal bzw. PVFM und Polyvinylbutyral bzw. PVB, ein Copolymer aus Ethylen und Chlortrifluorethylen bzw. ECTFE, Polypropylenen bzw. PP und einem Gemisch aus mindestens zwei dieser Verbindungen.

3. Der elektronische Schaltkreis nach Anspruch 1 oder 2, wobei die Dicke des Substrats (12) im Bereich von 30 µm bis 300 µm liegt.

4. Der elektronische Schaltkreis nach einem der Ansprüche 1 bis 3, wobei das zweite und dritte Polymer aus der Gruppe ausgewählt wird, die Folgendes aufweist:
Polyimide, Polybenzimidazol bzw. PBI, Polyetherimid bzw. PEI, Polyamidimid bzw. PAI, Polyethersulfon bzw. PES und ein Gemisch aus mindestens zwei dieser Verbindungen.

5. Der elektronische Schaltkreis nach einem der Ansprüche 1 bis 4, bei dem das Substrat (12), die erste Schicht (18) oder die ersten Bahnen (42) und/oder die zweite Schicht (20) oder die zweiten Bahnen (32) ferner ein mineralisches Pigment, ein organisches Pigment oder einen Farbstoff aufweisen.

6. Der elektronische Schaltkreis nach einem der Ansprüche 1 bis 5, wobei die Dicke der ersten Schicht (18), der ersten Bahnen (42), der zweiten Schicht (20), und/oder der zweiten Bahnen (32) im Bereich von 10 nm bis 300 nm liegt.

7. Der elektronische Schaltkreis nach einem der Ansprüche 1 bis 5, wobei die Dicke der ersten Schicht (18), der ersten Bahnen (42), der zweiten Schicht (20), und/oder der zweiten Bahnen (32) im Bereich von 10 µm bis 25 µm liegt.

8. Der elektronische Schaltkreis nach einem der Ansprüche 1 bis 7, wobei die die Dicke der dritten Bahnen (22) im Bereich von 500 nm bis 25 µm liegt.

9. Der elektronische Schaltkreis nach einem der Ansprüche 1 bis 8, wobei die ersten Bahnen (42) und/oder die zweiten Bahnen (32) parallele Streifen aufweisen, die mit einem Abstand angeordnet sind, der nicht konstant ist.

10. Verfahren zur Herstellung eine elektronischen Schaltkreises (10; 20; 30; 40), das folgende Schritte aufweist:
a) Bereitstellen eines Substrats (12) aus einem ersten Polymer mit einer ersten Glasübergangstemperatur von weniger als 200 °C, wobei das Substrat gegenüberliegende erste und zweite Oberflächen (14, 16) aufweist;
b) Ausbilden einer ersten Schicht (18) oder erster Bahnen (42) eines zweiten Polymers auf der ersten Oberfläche und einer zweiten Schicht (20) oder zweiter Bahnen (32) des zweiten Polymers oder eines dritten Polymers auf der zweiten Oberfläche, wobei sich die zweiten und dritten Polymere vom ersten Polymer unterscheiden und wobei sie eine zweite Glasübergangstemperatur über 200 °C aufweisen; und
c) Ausbilden dritter elektrisch leitender Bahnen (22) auf der ersten Schicht oder auf den ersten Bahnen.

11. Das Verfahren nach Anspruch 10, wobei Schritt c) sukzessive aufweist, eine leitfähige Farbe bzw. Tinte auf der ersten Schicht (18) oder auf den ersten Bahnen (42) aufzubringen und die Farbei bei einer Temperatur zu trocknen, die höher als die erste Glasübergangstemperatur ist.

## Claims

1. An electronic circuit (10; 20; 30; 40) comprising:
a substrate (12) made of a first polymer having a first glass transition temperature lower than 200°C, the substrate having first and second opposite surfaces (14, 16);
a first layer (18) or first tracks (42) of a second polymer on the first surface;
a second layer (20) or second tracks (32) of the second polymer or of a third polymer on the second surface, the second and third polymers being different from the first polymer and having a second glass transition temperature higher than 200°C; and
third electrically-conductive tracks (22) on the first layer or the first tracks.

2. The circuit of claim 1, wherein the first polymer is selected from the group comprising polycarbonate (PC), poly(ethylene terephthalate) (PET), poly(ethylene naphthalate) (PEN), styrenic polymers (particularly, the styrene acrylonitrile (SAN) copolymer, acrylate styrene acrylonitrile (ASA), and acrylonitrile butadiene styrene (ABS)), polymethyl methacrylate (PMMA), thermoplastic polyurethanes (TPU, particularly polyester-based TPU, polyether-based TPU), polyvinylidene fluoride (PVDF), polyvinyl resins (particularly polyvinyl acetate (PVAC), polyvinyl alcohol (PVAL), polyvinyl formal (PVFM), and polyvinyl butyral (PVB)), ethylene chlorotrifluoro-ethylene copolymer (ECTFE), polypropylenes (PP), and a mixture of at least two of these compounds

3. The electronic circuit of claim 1 or 2, wherein the thickness of the substrate (12) is in the range from 30 µm to 300 µm.

4. The electronic circuit of any of claims 1 to 3, wherein the second and third polymers are selected from the group comprising polyimides, polybenzimidazole (PBI), polyether-imide (PEI), polyamide-imide (PAI), polyethersulfone (PES), and a mixture of at least two of these compounds.

5. The electronic circuit of any of claims 1 to 4, wherein the substrate (12), the first layer (18) or the first tracks (42), and/or the second layer (20) or the second tracks (32) further comprise a mineral pigment, an organic pigment, or a dye.

6. The electronic circuit of any of claims 1 to 5, wherein the thickness of the first layer (18), of the first tracks (42), of the second layer (20), and/or of the second tracks (32) is in the range from 10 nm to 300 nm.

7. The electronic circuit of any of claims 1 to 5, wherein the thickness of the first layer (18), of the first tracks (42), of the second layer (20), and/or of the second tracks (32) is in the range from 10 µm to 25 µm.

8. The electronic circuit of any of claims 1 to 7, wherein the thickness of the third tracks (22) is in the range from 500 nm to 25 µm.

9. The electronic circuit of any of claims 1 to 8, wherein the first tracks (42) and/or the second tracks (32) comprise parallel strips arranged with a pitch which is not constant.

10. A method of manufacturing an electronic circuit (10; 20; 30; 40) comprising the steps of:
a) providing a substrate (12) made of a first polymer having a first glass transition temperature lower than 200°C, the substrate having first and second opposite surfaces (14, 16);
b) forming a first layer (18) or first tracks (42) of a second polymer on the first surface and a second layer (20) or second tracks (32) of the second polymer or of a third polymer on the second surface, the second and third polymers being different from the first polymer and having a second glass transition temperature higher than 200°C; and
c) forming third electrically-conductive tracks (22) on the first layer or the first tracks.

11. The method of claim 10, wherein step c) successively comprises depositing conductive ink on the first layer (18) or the first tracks (42) and drying the ink at a temperature greater than the first glass transition temperature.
